Europäisches Patentamt

European Patent Office

Office européen des brevets

(11) Numéro de publication: **0 320 321 B1**

(12) **FASCICULE DE BREVET EUROPEEN**

(45) Date de publication de fascicule du brevet: **17.06.92** (51) Int. Cl.⁵: **H01L 23/60, G11C 17/00**

(21) Numéro de dépôt: **88402729.3**

(22) Date de dépôt: **28.10.88**

(54) **Dispositif de fusion d'un fusible d'un circuit intégré.**

(30) Priorité: **06.11.87 FR 8715404**

(43) Date de publication de la demande:
**14.06.89 Bulletin 89/24**

(45) Mention de la délivrance du brevet:
**17.06.92 Bulletin 92/25**

(84) Etats contractants désignés:
**DE ES GB IT NL**

(56) Documents cités:
**EP-A- 0 059 630**
**EP-A- 0 084 000**
**EP-A- 0 148 510**

**PATENT ABSTRACTS OF JAPAN, vol. 8, no.
221 (E-271)[1658], 9 octobre 1984, page 148 E
271 & JP-A-59 105 354**

**PATENT ABSTRACTS OF JAPAN, vol. 9, no.
328 (E-369)[2051], 24 décembre 1985, page
111 E 369 & JP-A-60 160 654**

(73) Titulaire: **SGS-THOMSON MICROELECTRO-
NICS S.A.
7, Avenue Galliéni
F-94250 Gentilly(FR)**

(72) Inventeur: **Kowalski, Jacek
Cabinet Ballot-Schmit 84, Avenue Kléber
F-75116 Paris(FR)**
Inventeur: **Taillier, François
Cabinet Ballot-Schmit 84, Avenue Kléber
F-75116 Paris(FR)**

(74) Mandataire: **Ballot, Paul Denis Jacques et al
Cabinet Ballot-Schmit, 7, rue le Sueur
F-75116 Paris(FR)**

# Description

La présente invention a pour objet un dispositif de fusion d'un fusible dans un circuit intégré de type CMOS, Elle trouve son application dans de nombreux circuits integrés, notamment pour définir des mémoires mortes, ou pour y remplacer, par des circuits fonctionnels redondants, des circuits fonctionnels mis hors service. Dans des applications de cartes à mémoire les fusibles peuvent aussi servir à protéger, en accès, certaines zones des mémoires. Avant leur fusion, la connexion qu'ils établissent permet de programmer le circuit intégré de la carte à mémoire pour y introduire des codes secrets ou des algorithmes de reconnaissance. Après leur fusion, cette programmation ainsi qu'une lecture de ces codes secrets ou de ces algorithmes deviennent impossibles.

Dans un circuit intégré les fusibles sont principalement réalisés par des connexions en polysilicium ou en métal. Les dimensions de la section de ces connexions ainsi que la longueur utile de fusion du fusible sont déterminées en fonction d'un courant nominal de fusion. Le principe de la fusion d'un fusible est simple . Il suffit de faire passer par le fusible un courant suffisamment important afin de le faire fondre. En pratique ce courant, dans les circuits intégrés modernes, est de l'ordre de quelques dizaines de milliampères. Après la fusion du fusible, une des bornes du fusible, celle à laquelle on voulait rendre impossible l'accès, se trouve électriquement en l'air. Pour éviter une telle situation, cette borne du fusible est reliée à un détecteur de niveau. Ce détecteur de niveau est susceptible d'une part de révéler la fusion du fusible, et d'autre part de maintenir à un potentiel constant l'extrémité de la connexion en l'air.

Il y a cependant des problèmes liés à la fusion du fusible. D'abord le courant de fusion doit être assez important, ce qui demande, pour l'acheminement de ce courant, un transistor de commande très grand. Ce transistor de commande sert à faciliter la programmation de la fusion des divers fusibles d'un circuit. La grosseur du transistor est liée au courant que ce transistor doit laisser passer. D'autre part, le front de montée de l'impulsion de courant doit être très raide. En effet, si la montée en courant est lente, toutes proportions gardées, le fusible fond petit à petit. Au fur et à mesure qu'il fond, sa résistance électrique augmente. En effet, par exemple, les dimensions de sa section peuvent se réduire au cours de cette fusion. Comme cette résistance augmente, l'énergie que le fusible est susceptible de dissiper diminue. Comme cette énergie diminue, le fusible chauffe de moins en moins au risque de ne plus pouvoir fondre. Si ce phénomène se produit, il est ultérieurement impossible de faire fondre le fusible. Enfin, la commande du transistor d'acheminement du courant nécéssite de prévoir, dans la procédure de fusion d'un fusible, l'application d'un ordre de fin de fusion qui complique cette procédure. En pratique, il faut prévoir un temps de fusion. Et ce temps de fusion doit être relativement grand afin d'assurer une bonne fusion dans tous les cas.

Les fusibles présentent par ailleurs une grande fragilité aux décharges électrostatiques. Cette fragilité est due essentiellement à la présence du gros transistor de commande de la fusion du fusible. En effet, du fait de sa grosseur, ce transistor ne constitue pas une bonne protection vis à vis de décharges électrostatiques de haute tension, même si son entrée de commande est désactivée. Il est en effet possible que ce gros transistor laisse passer l'énergie des décharges électrostatiques lorsque le circuit intégré est manipulé, notamment en fin de fabrication et au moment de l' installation de ce circuit intégré dans un système électronique. Ces décharges électrostatiques répétées peuvent avoir le même effet qu'un front de montée trop lent du courant du fusion. Au moment où on veut faire fondre le fusible, la résistance de celui-ci peut être importante à cause des amorces de fusion qu'il a subies . L'énergie qu'il est susceptible de dissiper est alors trop faible : il ne fond plus.

La présente invention a pour objet de remédier à ces inconvénients tout en ne s'appliquant cependant qu'aux circuits intégrés de type CMOS. Cette restriction n'est pas gênante, car actuellement la technologie CMOS est de plus en plus utilisée, notamment elle est souvent préférée à la technologie NMOS. La technologie CMOS se caractérise par un substrat semiconducteur d'un type de conductivité donnée (généralement de type P) dans lequel sont réalisés des caissons d'isolement par implantation d'impuretés correspondant à un type de conductivité opposée (généralement de type N). Des transistors et des jonctions diverses peuvent être ménagés par implantation de régions dopées avec un type d'inpuretés ou un autre soit dans le substrat soit dans ces caissons.

La technologie CMOS est cependant connue pour souffrir d'un phénomène de basculement de conduction, dit de "latch up" dans la littérature anglo-saxonne. Ce basculement correspond à un déclenchement de thyristors parasites qui sont naturellement créés dans un circuit CMOS avec caissons. Ces thyristors parasites sont formés par une succession de régions de types de conductivité alternées. Une première région, d'un type de conductivité donnée (généralement P) est contenue dans un caisson d'un deuxième type de conductivité donnée (généralement N), ce caisson est lui-même placé dans un substrat du premier type de conductivité donnée (généralement P), et comporte une ou des régions du deuxième type de conductivité (généralement N). La succession de ces quatre régions de conductivité alternée constitue un thyristor dont le maintien au blocage est dans certains cas délicat.

Dans l'invention on met cependant à profit l'existence de ce thyristor parasite pour faire fondre le fusible en raccordant une borne de ce fusible à ce thyristor et en le déclenchant. Au moment de la fusion, le courant est fourni par un générateur de potentiel de fusion. Le courant traverse le fusible et le thyristor dont une des bornes est reliée à l'autre pôle du générateur de potentiel de fusion. L'utilisation d'un thyristor parasite pour la fusion d'un fusible est décrite dans le "Patent Abstracts of Japan, Vol.8, n°221 (E-271) [1658], 9.10.1984, page 148. Ce document décrit un dispositif selon la partie précaractérisante de la revendication 1.

D'une part le thyristor, tout en étant de taille plus faible, accepte un courant très fort. D'autre part le thyristor conduit tant que le fusible n'est pas complètement fondu: tant que le fusible laisse passer du courant. Dès que le fusible est fondu, le thyristor se désamorce, il n'est pas nécessaire de prévoir dans la procédure un ordre de fin de fusion.

Dans l'invention,on propose un dispositif de déclenchement avec une structure circulaire. Ainsi, quand il n'est pas déclenché, ce thyristor parasite présente une protection du fusible, à l'égard des décharges électrostatiques, bien plus grande que dans l'état de la technique cité.

L'invention a donc pour objet un dispositif de fusion d'un fusible dans un circuit intégré de type CMOS tel que caractérisé dans la revendication 1.

Les revendicationes 2 et 3 concernent des réalisations avantageuses.

L'invention sera mieux comprise à la lecture de la description qui suit, et à l'examen des figures qui l'accompagnent. Elles ne sont données qu'à titre indicatif et nullement limitatif de l'invention. Les figures montrent :
- figure 1 : une coupe d'un circuit intégré de type CMOS muni d'un thyristor parasite;
- figure 2 : le schéma équivalent du circuit représenté par ce thyristor parasite;
- figure 3 : un dispositif de déclenchement d'un thyristor parasite avec une structure circulaire selon l'invention;
- figure 4 : une variante d'un circuit de déclenchement non conforme à l'invention;
- figure 5 : une représentation schématique d'un détecteur de niveau pour vérifier l'état de fusion du fusible :
- figure 6 : un perfectionnement technologique d'un transistor de rappel de ce détecteur de niveau.

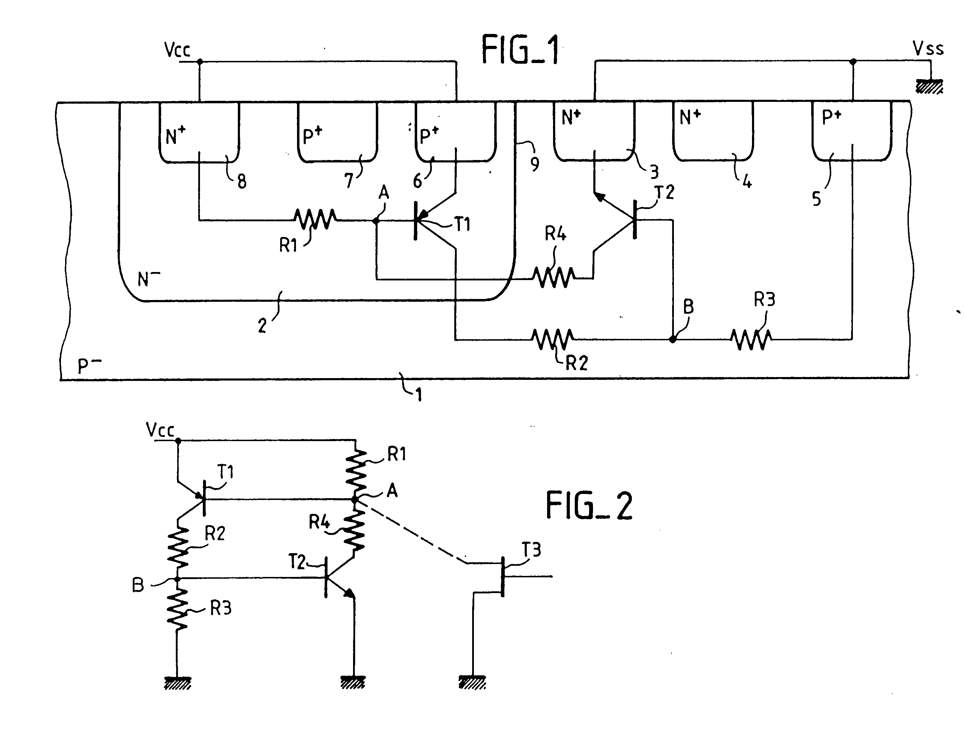

La figure 1 représente un thyristor parasite d'un circuit intégré de type CMOS. Ce circuit intégré, non représenté, est intégré dans un substrat 1, ici de type P- comportant des caissons, notamment un caisson 2, de conductivité inverse : N-. Classiquement le substrat 1 comporte des régions dopées 3 et 4 avec des mêmes impuretés que celles qui ont servi à doper le caisson 2 mais en plus grande concentration : N+ Elles servent à réaliser diverses fonctions électroniques, notamment des transistors. Le substrat comporte également une prise de substrat 5 constituée par une région dopée avec des mêmes impuretés, mais avec une concentration plus élevée P+, que le substrat luimême. Cette prise de substrat sert à polariser le substrat à un potentiel fixe. Quand le substrat est de type P ce potentiel fixe VSS vaut généralement zéro volts, il peut même être inférieur à zéro. Une des régions dopées N+ dans le substrat, par exemple ici la région 3 proche du caisson 2, est également polarisée au potentiel vss.

Le caisson 2 comporte d'une manière analogue des régions 6 et 7, dopées P+ avec des impuretés différentes de celles qui ont servi à doper le caisson 2. Il comporte également une région E, dopée N+ avec des mêmes impuretés que pour luimême, qui sert de prise de caisson. En général, une prise de caisson est polarisée à un potentiel inverse du potentiel de polarisation de substrat. Avec un substrat de type P et des caissons de type N le caisson est polarisé positivement à Vcc. Une des régions dopées P+ dans le caisson, par exemple ici la région 6 proche de la région 3, est également polarisée au potentiel VCC. On peut déterminer que les régions fortement dopées 3 et 6, de part et d'autre de la frontière 9 du caisson dans le substrat 1, en combinaison avec le caisson 2 et le substrat 1 constituent un thyristor parasite de type P+ N- P- N+. On peut accéder aux régions intermédiaires de ce thyristor par les prises 8 de caisson et 5 de substrat respectivement.

Le schéma équivalent de ce thyristor est représenté sur la figure 2. Dans le caisson, la région 6, le caisson 2, et le substrat 1 forment un transistor T1 bipolaire. Dans le substrat, la région 3, le substrat 1, et le caisson 2 forment un transistor bipolaire T2. Tout se passe comme si le transistor T1 dans l'exemple de type PNP était relié par son émetteur à Vcc (dans la région 6, figure 1), était relié par son collecteur, par l'intermédiaire de résistances R2 et R3 en série, à la prise de substrat 5, et était relié par sa base, par l'intermédiaire d'une résistance R1, à la prise 8 de caisson. Le transistor T2, de type NPN peut être considéré comme relié par son émetteur à la région 3, par son collecteur, par l'intermédiaire de résistances en série R1 et R4, à la région 8, et par sa base, par l'intermédiaire de la résistance R3, à la prise 5 de substrat. Les bases de ces transistors, respectivement les points A et B, sont donc reliées aux points milieux des ponts de résistance respectivement R1-R4, et R2-R3.

Au repos, le thyristor n'est pas conducteur. La tension au point A est égale à la tension Vcc, et la tension au point B est égale à VSS. Les deux transistors T1 et T2 sont bloqués. Pour déclencher le thyristor, il suffit de faire baisser la tension au point A jusqu'à ce que le transistor T1 commence à conduire. Il suffit par exemple de faire baisser cette tension de 0,6 volts. Cette chute de tension est égale à la tension emetteur-base du transistor T1. Dès que le transistor T1 se met à conduire, la tension au point B monte du fait que du courant passe dans la résistance R3. En conséquence, le transistor T2 qui était bloqué devient passant. Comme le transistor T2 devient passant, du courant passe maintenant dans les résistances R1 et R4. Ceci continue à faire chuter la tension au point A et a pour résultat une réaction positive. Le phénomène de basculement se produit alors. Les deux transistors entrent en saturation en faisant passer un courant très important (quelques centaines de milliampères) entre l'alimentation Vcc et le potentiel de masse VSS. Seuls une coupure ou un écroulement de l'alimentation Vcc peuvent arrêter ce phénomène.

L'idée de l'invention est d'utiliser un moyen de commande pour faire chuter le potentiel du point A, ou réciproquement pour faire monter le potentiel du point B lorsque le thyristor est bloqué. La description qui va suivre correspond, sans qu'on puisse en déduire une quelconque restriction, à cette première solution : faire baisser la tension au point A.

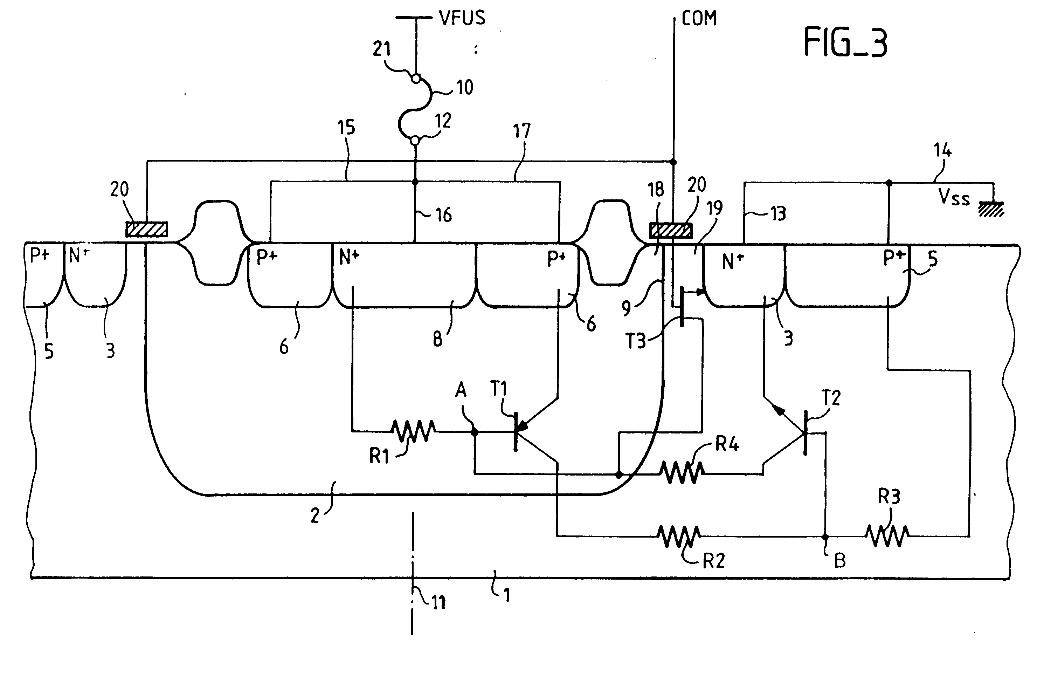

La figure 3 montre en coupe une réalisation d'un Circuit de déclenchement du thyristor selon l'invention. Dans cette figure, le fusible 10 a été représenté ainsi que son alimentation avec une tension de fusion VFUS qui peut être spécifique. Dans l'invention néanmoins, du fait de la plus grande efficacité du thyristor, on peut arriver à faire fondre les fusibles avec une tension plus faible que Vcc. Dans sa réalisation le dispositif de fusion du fusible est de type circulaire, centré autour d'un axe 11 situé sensiblement à l'aplomb de la borne 12 du fusible la plus proche du thyristor. Le thyristor parasite de déclenchement comporte donc une région centrale 8 dopée N+, entourée par une région en couronne 6 dopée P+. Ces régions 8 et 6 sont contenues dans le caisson 2 également de type circulaire, lui même entouré par une région circulaire 3 de type N+ dans le substrat. La région 3 est elle-même contenue dans un autre région circulaire 5 dopée P+. Les régions 8, 6, 3 et 5 ont ici les mêmes fonctions que celles présentées ci-dessus. Les régions 3 et 5 sont raccordées par des connexions 13 et 14 au potentiel de polarisation du substrat. Les deux régions 6 et 8 du caisson 2 sont reliées en commun à la borne 12 du fusible 6 par des connexions 15 à 17.

Un transistor MOS T3 de déclenchement du thyristor est constitué par une zone limitrophe 18 du caisson 2, proche de la frontière 9, par une zone 19 du substrat, en vis à vis de cette zone 18 de l'autre côté de la frontière 9, et par la région 3 annulaire dopée N+. Ce transistor hybride est donc constitué de régions dont les concentrations en impuretés sont respectivement N-, P- et N+. Une grille 20 superposée au dessus d'un oxyde de grille d'isolement électrique non représenté est alimentée par un signal de commande COM. La grille 20 est à cheval sur la frontière 9. Elle gouverne effectivement la conduction du transistor T3 dans la zone 19. Elle est sans influence sur la zone 18 et donc il n'est pas gênant de la laisser déborder au dessus de cette zone 18. Au moment de l'application d'une impulsion positive sur la grille 20, du courant circule dans le transistor T3 ainsi constitué. Ce courant ne peut provenir que du caisson 2. Du fait de la résistance interne du matériau semi-conducteur du caisson (résistance R1), le potentiel dans ce caisson 2 chute. On provoque ainsi la chute de potentiel au point A. Pour que le phénomène de déclenchement du thyristor se produise il faut cependant faire en sorte que le transistor T3 puisse assurer une chute de tension d'au minimum 0,6 volts sur le point A. Pour celà la résistance R1 doit être relativement grande et la résistance R4 relativement petite. En outre, il faut que le transistor T3 ne soit pas lui-même trop résistif. La figure 2 montre avec des tirets le mode de raccordement du transistor T3 dans le schéma équivalent du thyristor.

La solution présentée sur la figure 3 a d'autres avantages importants. Elle permet en particulier de se protéger très efficacement des décharges de type électrostatique. Considérons par exemple que, sur la borne 21 du fusible, un dispositif de protection contre des décharges électrostatiques supérieures à 20 volts soit branché en parallèle. Dans l'état de la technique cité, le transistor de fusion du fusible déclenchait généralement à une même tension que le dispositif de protection (par exemple par avalanche de jonction ou BVdSS), ou même éventuellement à une tension plus basse. Ceci conduisait à la détérioration du fusible, ou éventuellement à sa destruction inopinée. Dans le dispositif représenté la conduction de la jonction de type N-P- entre le caisson et le substrat est située, du fait des faibles concentrations d'impuretés au voisinage de cette jonction, à typiquement 100 à 150 volts. Dans ces conditions le dispositif de protection du fusible est toujours sollicité en premier. Il joue son rôle normalement : le fusible ne peut pas être détérioré.

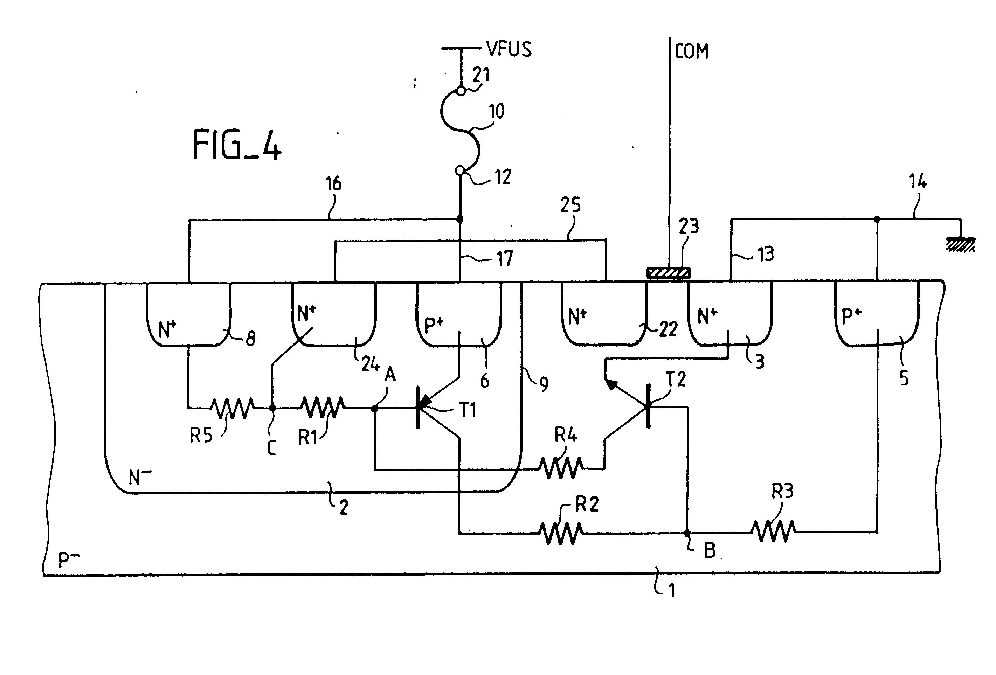

Le dispositif représenté sur la figure 4, non conforme à l'invention, assure une moins bonne protection aux décharges électrostatiques. Le transistor de déclenchement du thyristor est un transistor MOS classique. Il comporte une région 22 proche de la frontière 9 ainsi que la région 3 située à proximité de la région 22, de même concentration d'impuretés qu'elle (N+). La région 22 est séparée de la région 3 par une distance correspondant au canal de conduction de ce transistor. Ce canal est commandé par une grille 23 recevant le signal de commande COM. Le caisson 2 comporte en outre une autre région 24, dopée N+, jouant le rôle de prise de caisson secondaire et reliée électriquement par une connexion 25 à la région 22 du transistor de commande. Dans cette variante, la région 22 n'est plus reliée directement au potentiel VSS. Elle n'y est reliée que conditionnellement : lorsque le signal COM est appliqué sur la grille 23 et qu'il rend le transistor 3-22 conducteur. Le transistor de commande est donc ici un transistor MOS classique.

Avant de faire fondre le fusible, le potentiel disponible sur la connexion 25 est sensiblement le potentiel VFUS. Lorsque la commande de fusion est appliquée sur la grille 23, le transistor 22-23-3 se met à conduire de telle sorte que le potentiel d'un point milieu C d'un pont diviseur formé par des résistances R5 R1 chute. A ce moment aucun courant ne passe dans la résistance R1. Mais du fait de la position géographique de la région 24, entre la région 8 et la région 6, la chute du potentiel au point C entraîne une chute sensiblement égale du potentiel au point A du transistor T1. Dans ces conditions, le phénomène attendu , le déclenchement du thyristor, se produit.

L'intérêt de ce dispositif réside dans la réalisation d'un transistor 22-23-3 de type classique par opposition au transistor hybride 18-19-3 de la figure 3. Cependant, dans cette variante, la protection contre les décharges électrostatiques est moins bien assurée. En effet une décharge électrostatique peut emprunter un chemin passant successivement par la connexion 15, la région 8, le caisson 2 la région 24, la connnexion 25, et la région 22 avant d'aller à la masse par avalanche de la jonction 22-1 et BVdSS du transistor de commande. Dans ces conditons c'est la jonction 22-1 et la longueur du canal du transistor T3 qui assurent la tenue en tension contre cette décharge. Comme la région 22 est fortement dopée, la barrière de potentiel de cette jonction est plus faible. On est alors confronté à un inconvénient du même type, de ce point de vue, que dans l'état de la technique cité.

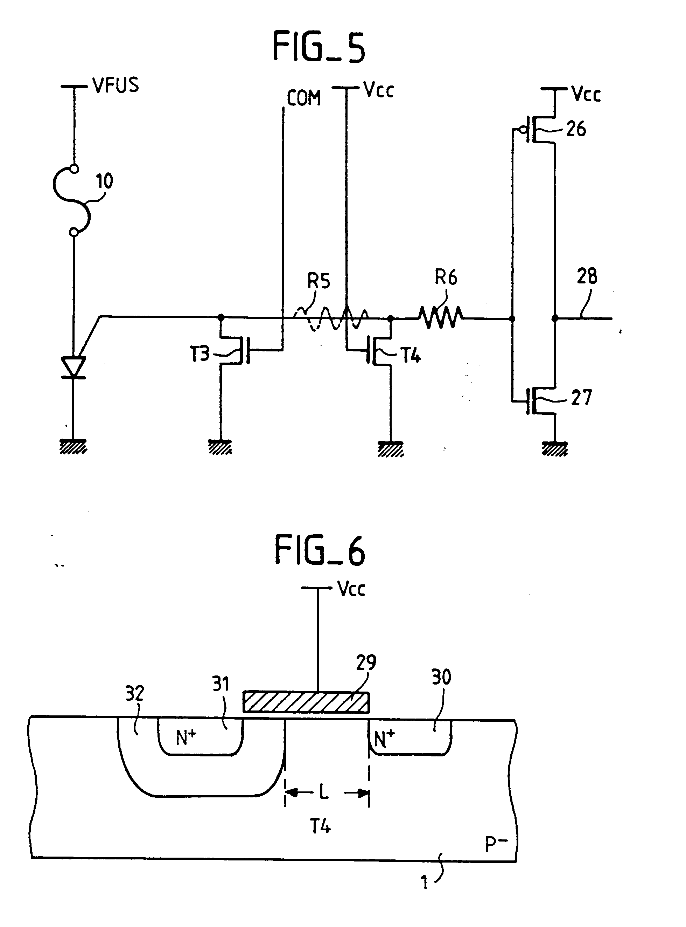

Il peut y avoir une multitude de circuits de détection de l'état du fusible. La figure 5 en représente un exemple. Ce circuit comporte essentiellement un transistor de rappel T4 et un inverseur de détection comportant deux transistors 26, 27. Les transistors 26 et 27 sont branchés en série entre l'alimentation Vcc du circuit intégré et la masse.

Lorsque l'inverseur de détection détecte le changement d'état du fusible, il bascule. La sortie 28 du détecteur de niveau est connectée au point milieu des deux transistors 26 et 27. Ces deux transistors sont commandés en - commun, par l'intermédiaire d'une résistance R6, par un potentiel disponible aux bornes d'un transistor T4. Le transistor T4 est branché en parallèle aux bornes du transistor T3, il reçoit le potentiel Vcc sur sa grille. Lorsque le fusible a fondu, lorsque la commande COM a cessé, le transistor T4 provoque la mise à la masse de l'entrée des transistors 25 et 27. Le transistor 27 est alors bloqué, tandis que le transistor 26 est conducteur. La sortie 28 est portée au potentiel Vcc. La présence de la résistance R 6 sert à protéger le fusible 10 des décharges électrostatiques qui pourraient passer par les transistors 26 ou 27. Au moment d'une telle décharge, une grande différence de potentiel se déploie dans la résistance R6 de telle façon que la barrière de potentiel du transistor 27 soit suffisante pour résister aux résidus de cette décharge électrostatique. Par contre ceci n'est pas envisageable avec le transistor T4 qui est quasiment toujours conducteur ni avec le transistor T3 de la variante de la figure 4.

Pour néanmoins atteindre ce but, ces deux transistors peuvent être réalisés de la manière représentée sur la figure 6. De préférence les transistors T3 et T4 comprennent une grille 29 qui gouverne un canal de conduction entre deux régions 30 et 31 dopées N+. Une de leurs régions, la région 31, celle qui est géographiquement la plus proche du thyristor dans le substrat 1, est implantée dans un caisson 32 dopé N-. Du fait de la faible concentration des impuretés dans le caisson 32, la jonction N- P- entre ce caisson et le substrat résiste aux décharges électrostatiques. Une différence de potentiel de 150 volts peut par exemple être maintenue (en pratique elle peut cependant être limitée par le claquage de l'oxyde de grille entre la région 32 et la grille 29, vers 50 volts). La longueur du canal doit cependant être suffisante pour éviter un passage en perçage prématuré du transistor T4.

## Revendications

1. Dispositif de fusion d'un fusible dans un circuit intégré de type CMOS comportant un thyristor en série avec le fusible et des moyens pour commander la mise en conduction du thyristor comprenant un transistor MOS dont la grille de contrôle est connectée à un signal de commande du thyristor, caractérisé en ce que ce dispositif a une structure circulaire, le thyristor comprenant :

    un substrat (1) du circuit intégré, d'un premier type de conductivité,

    un caisson (2) d'un second type de conductivité réalisé dans le substrat,

une première région (8) au centre du caisson, de même type de conductivité mais plus dopé que le caisson,

une seconde région (6) dans le caisson, de même type de conductivité mais plus dopé que le substrat, cette seconde région (6) entourant la région centrale (8),

une troisième région (3) dans le substrat, de même type de conductivité mais plus dopé que le caisson, cette troisième région (3) entourant le caisson,

une quatrième région (5) dans le substrat, de même type de conductivité mais plus dopé que le substrat, cette quatrième région (5) entourant la région (3);

la première région (8) et la seconde région (6) étant connectée à une borne (12) du fusible, la troisième région (3) et la quatrième région (5) étant connectées en commun à une tension de polarisation (14) du substrat;

le transistor MOS (T3) étant formé par l'alignement d'une zone (18) du caisson proche de la frontière (9) entre le caisson et le substrat, d'une zone (19) du substrat proche de ladite frontière et de la troisième région (3) du thyristor, la grille de contrôle (20) étant placée au dessus, à cheval sur la frontière (9).

**2.** Dispositif selon la revendication 1, caractérisé en ce que ce thyristor est du type parasite de ce circuit intégré.

**3.** Dispositif selon la revendication 1 ou 2, un circuit de détection étant relié à la borne (12) du fusible connectée au thyristor, pour la détection de la fusion du fusible et pour le forçage du potentiel de la borne (12) du fusible et comprenant un transistor de rappel (T4) en série entre cette borne (12) du fusible et la masse, ce transistor de rappel (T4) étant caractérisé en ce qu'il est branché en parallèle aux bornes du transistor MOS (T3) et qu'il comporte deux régions du second type de conductivité réalisées dans le substrat (1) du premier type de conductivité, l'une des deux régions géographiquement la plus proche du thyristor étant réalisée dans un domaine plus vaste qu'elle, de même type de conductivité mais moins dopée qu'elle.

**Claims**

**1.** A device for fusing a fuse in an integrated circuit of the CMOS type comprising a thyristor in series with the fuse and means for controlling the switching on of the thyristor comprising an MOS transistor the control gate of which is connected to a thyristor control signal, characterized in that this device has a circular structure, the thyristor comprising:

an integrated circuit substrate (1) of a first conductivity type,

an island (2) of a second conductivity type formed in the substrate,

a first region (8), in the centre of the island, having the same conductivity type as but being more highly doped than the island,

a second region (6) in the island having the same conductivity type as but being more highly doped than the substrate, this second region (6) surrounding the central region (8),

a third region (3) in the substrate, having the same type of conductivity as but being more highly doped than the island, this third region (3) surrounding the island,

a fourth region (5) in the substrate having the same type of conductivity as but being more highly doped than the substrate, this fourth region (5) surrounding the region (3), the first region (8) and the second region (6) being connected to a terminal (12) of the fuse, the third region (3) and the fourth region (5) being connected in common to a polarisation voltage (14) of the substrate,

the MOS transistor (T3) being formed by the alignment of a zone (18) of the island adjacent to the boundary (9) between the island and the substrate, of a zone (19) in the substrate adjacent to the said boundary (9) and of the third region (3) of the thyristor, the control gate (20) being located above, bridging the boundary (9).

**2.** A device as claimed in claim 1, characterized in that the thyristor is of the parasitic type in the integrated circuit.

**3.** A device as claimed in claim 1 or claim 2, having a detection circuit connected to the terminal (12) of the fuse connected to the thyristor, for detecting fusing of the fuse and for forcing the potential at the terminal (12) of the fuse, and comprising a pull down transistor (T4) connected in series between this terminal (12) of the fuse and ground, this setting transistor (T4) being characterized in that it is connected in parallel to the terminals of the MOS transistor (T3) and in that it comprises two regions having the second conductivity type formed in the substrate (1) having the first conductivity type, that one of the two regions which is spatially closer to the thyristor being formed in a region which is larger than it is and which has the same conductivity type as it has but is less highly doped.

## Patentansprüche

1. Anordnung zum Schmelzen einer Sicherung in einer integrierten CMOS-Schaltung mit einem Thyristor in Reihe mit der Sicherung und Einrichtungen, die das überführen des Thyristors in den leitenden Zustand steuern und die einen MOS-Transistor umfassen, dessen Steuergate ein Steuersignal für das Thyristor zugeleitet wird, dadurch gekennzeichnet, daß die Anordnung eine zirkulare Struktur aufweist, wobei der Thyristor:

ein Substrat (1) der integrierten Schaltung mit einem ersten Leitfahigkeitstyp,

eine in dem Substrat erzeugte Insel (2) mit einem zweiten Leitfahigkeitstyp,

einen ersten mittig in der Insel angeordneten Bereich (8) des gleichen Leitfähigkeitstyps aber mit höherem Dotierungsgrad als der der Insel,

einen zweiten in der Insel angeordneten Bereich (6) des gleichen Leitfähigkeitstyps aber mit höherem Dotierungsgrad als der des Substrats, wobei dieser zweite Bereich (6) den mittigen Bereich (8) umgibt,

einen dritten in dem Substrat angeordneten Bereich (3) des gleichen Leitfähigkeitstyps aber mit höherem Dotierungsgrad als der der Insel, wobei dieser dritte Bereich (3) die Insel umgibt,

einen vierten in dem Substrat angeordneten Bereich (5) des gleichen Leitfähigkeitstyps aber mit höherem Dotierungsgrad als der des Substrats, wobei dieser vierte Bereich (5) den Bereich (3) umgibt, aufweist,

wobei der erste Bereich (8) und der zweite Bereich (6) mit einer Klemme (12) der Sicherung verbunden sind, wobei der dritte Bereich (3) und der vierte Bereich (5) jeweils mit einer Quelle einer Polarisierungsspannung (14) des Substrats verbunden sind,

wobei der MOS-Transistor (T3) durch das Ausfluchten einer Zone (18) der Insel im Bereich der Grenze (9) zwischen der Insel und dem Substrat, einer Zone (19) des Substrats im Bereich der Grenze und des dritten Bereiches (3) des Thyristor erzeugt wird, wobei das Steuergate (20) oberhalb der Grenze (9) diese überspannend angeordnet ist.

2. Anordnung nach Anspruch 1, dadurch gekennzeichnet, daß der Thyristor in bezug auf die integrierten Schaltung parasitären Typs ist.

3. Anordnung nach Anspruch 1 oder Anspruch 2, wobei eine Erfassungsschaltung mit der Klemme (12) der mit dem Thyristor verbundenen Sicherung verbunden ist, um das Schmelzen der Sicherung festzustellen und um das Potential der Klemme (12) zu erhöhen, mit einer Rücklauftransistor (T4) in Reihe zwischen dieser Klemme (12) der Sicherung und Masse, wobei dieser Relaistransistor (T4) dadurch gekennzeichnet ist, daß sie mit der Klemme des MOS-Transistors (T3) in parallel verbunden ist und daß er zwei Bereiche des zweiten Leitfähigkeitstyps aufweist, die im Substrat (1) der ersten Leitfähigkeitstyps vorhanden sind, wobei einer der zwei Bereiche, der raummassig dem Thyristor am nächsten angeordnet ist, aus einem weitreichenderen Domän besteht als er, und den gleichen Leitfähigkeitstyp besitzt aber geringer dotiert ist.

FIG_1

FIG_2

Vss
Vcc
P+ — 5
N+ — 4
R3
N+ — 3
T2
B
R4
R2
9
P+ — 6
T1
A
P+ — 7
R1
N+ — 8
2
N⁻
P⁻
1

R1
A
T3
R4
T2
T1
R2
B
R3
Vcc

FIG_3

EP 0 320 321 B1

# FIG_4

VFUS

COM

EP 0 320 321 B1

## FIG_5

## FIG_6